# EUROPÄISCHE PATENTSCHRIFT

(11) **EP 2 384 286 B1**
(45) Veröffentlichungstag und Bekanntmachung des Hinweises auf die Patenterteilung: **09.09.2015**
(21) Anmeldenummer: 10731744.8
(22) Anmeldetag: 12.07.2010
(51) Int. Cl.: B60L 3/00, G01R 31/34, H02P 29/02

(54) **VERFAHREN ZUR DIAGNOSE VON STROMSENSOREN EINER DREHFELDMASCHINE WÄHREND DEREN BETRIEBS**
METHOD FOR DIAGNOSING CURRENT SENSORS IN AN INDUCTION MACHINE DURING OPERATION THEREOF
PROCÉDÉ POUR DIAGNOSTIQUER DES CAPTEURS DE COURANT D'UN GÉNÉRATEUR À INDUCTION PENDANT SON FONCTIONNEMENT

(30) Priorität: 24.07.2009 DE 102009034595
(43) Veröffentlichungstag der Anmeldung: 09.11.2011
(73) Patentinhaber: Conti Temic Microelectronic GmbH, 90411 Nürnberg (DE)
(72) Erfinder: GREIF, Andreas, 91077 Neunkirchen/Brand (DE); WAGNER, Bernhard, 90489 Nürnberg (DE)
(74) Vertreter: Bonn, Roman Klemens
(86) Internationale Anmeldenummer: PCT/EP2010/059996
(87) Internationale Veröffentlichungsnummer: WO 2011/009751

(56) Entgegenhaltungen:
- EP-A2- 2 184 846
- US-A1- 2002 008 492
- US-A1- 2008 036 415
- US-B1- 7 002 318

## Beschreibung

Die Erfindung betrifft ein Verfahren zur Diagnose von Stromsensoren einer n-phasigen Drehfeldmaschine mit n-1 Stromsensoren während deren Betriebs.

Zur Regelung von elektrischen Drehfeldmaschinen, zum Beispiel zur Verwendung als Antrieb in Fahrzeugen, werden unter anderem Stromsensoren benötigt, um die Phasenströme zu erfassen. Dabei werden für eine n-phasige Drehfeldmaschine mindestens n-1 Stromsensoren benötigt, um alle Phasenströme zu erfassen. Für eine übliche 3-phasige Drehfeldmaschine bedeutet dies zum Beispiel, dass 2 Stromsensoren für zwei Phasen der 3-phasigen Drehfeldmaschine vorgesehen sind. Aus den n-1 gemessenen Phasenströmen kann auf den n-ten Phasenstrom geschlossen werden, da die Summe der Phasenströme einer Drehfeldmaschine zu jedem Zeitpunkt immer den Wert Null ergibt. Dabei besteht die Anforderung, die Stromsensorik im laufenden Betrieb zu überwachen mit dem Ziel, eine eventuell notwendige Nachkalibrierung von Stromsensoren durchzuführen oder einen defekten Stromsensor zu identifizieren.

Treten in Stromsensoren Fehler auf, wie zum Beispiel Offsetfehler, Verstärkungsfehler, Leitungsunterbrechungen oder Kurzschlüsse, kann als Folge davon ein falsches Drehmoment der Drehfeldmaschine erzeugt werden. Die unerwünschten Auswirkungen von falschen Drehmomenten auf Grund von Sensorfehlern können zum Beispiel ein pendelndes Drehmoment, Geräuschentwicklung und Vibrationen, aber auch eine Personengefährdung durch unerwünschte oder zu große Beschleunigung oder Verzögerung beim Einsatz einer Drehfeldmaschine als Antrieb in einem Fahrzeug sein.

Ein nach dem Stand der Technik bekannter Ansatz zur Diagnose von Stromsensoren ist es, zusätzlich zu den mindestens zur Regelung benötigten n-1 Stromsensoren einen weiteren Stromsensor einzusetzen, so dass alle Phasen einer Drehfeldmaschine überwacht werden können. Zum Beispiel wird in einer 3-phasigen Drehfeldmaschine ein dritter Stromsensor vorgesehen.

Nachteilig wirken sich dabei die erhöhten Kosten aus. Da in einer n-phasigen Drehfeldmaschine die Summe aller Phasenströme immer gleich Null sein muss, misst man alle Ströme und überprüft, ob die Summe der in dem beschriebenen Fall n Stromsensorsignale unter Beachtung einer geeignet vorgegebenen Toleranz gleich Null ist. Auf diese Weise kann ein einzelner Stromsensorfehler festgestellt werden. Dabei ist jedoch nicht in jedem Fall eine Zuordnung möglich, welcher der Stromsensoren defekt ist. Eine Nachkalibrierung eines Sensors ist mit diesem Verfahren ebenfalls nicht möglich.

Verfahren zur Diagnose von Stromsensoren sind beispielweise auch in den Schriften US 2002 008 492 A und US 7 002 318 B beschrieben.

Aufgabe der vorliegenden Erfindung ist es, ein Verfahren zur Diagnose von Stromsensoren einer n-phasigen Drehfeldmaschine mit n-1 Stromsensoren während deren Betriebes anzugeben, bei dem die genannten Nachteile vermieden werden.

Die Aufgabe wird gelöst durch ein Verfahren gemäß Anspruch 1. Ausgestaltungen und Weiterbildungen des Erfindungsgedankens sind Gegenstand von Unteransprüchen.

Die Aufgabe wird insbesondere gelöst durch ein Verfahren zur Diagnose von Stromsensoren einer n-phasigen Drehfeldmaschine mit n-1 Stromsensoren, bei dem während des Normalbetriebs der Drehfeldmaschine die n Phasen der Drehfeldmaschine für eine kurze Zeitdauer kurzgeschlossen werden und während des Kurzschlussbetriebs die zeitlichen Verläufe der n-1 Kurzschlussströme durch die n-1 Stromsensoren gemessen werden. Die Istwerte der zeitlichen Verläufe der n-1 gemessenen Kurzschlussströme werden mit entsprechenden vorgegebenen Sollwerten für die n-1 Kurzschlussströme verglichen. Aus dem Vergleich wird auf einen möglichen Fehlerzustand eines oder mehrerer Stromsensoren geschlossen.

Die Erfindung wird nachfolgend anhand der in den Figuren der Zeichnungen dargestellten Ausführungsbeispiele näher erläutert, wobei gleiche Elemente mit gleichen Bezugszeichen versehen sind. Es zeigt:
- Figur 1: in einem Diagramm drehzahlabhängige Ströme und Kurzschlussmomente einer kurzgeschlossenen Synchronmaschine;
- Figur 2: in einem Ablaufdiagramm eine Ausführungsform des erfindungsgemäßen Verfahrens; und
- Figur 3: Figur 3 zeigt ein Beispiel eines Antriebsumrichters für einen drei-phasigen Motor M mit Stromsensoren und einer B6-Brückenschaltung.

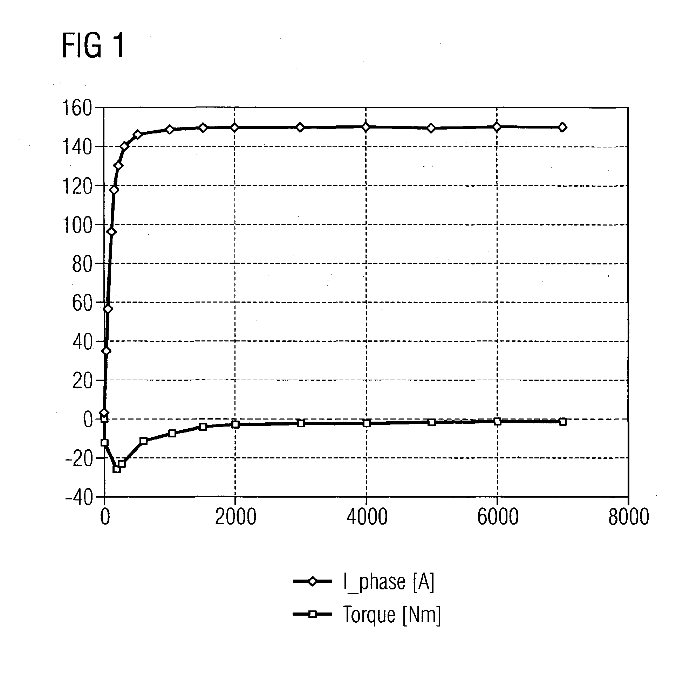

Figur 1 zeigt in einem Diagramm drehzahlabhängige Ströme und Kurzschlussmomente einer kurzgeschlossenen, als permanenterregten Synchronmaschine ausgeführten Drehfeldmaschine. Schließt man die Klemmen einer erregten Synchronmaschine kurz und treibt diese an (zum Beispiel beim Nachlaufen des Motors aufgrund von Schwungmassen), fließen durch die Phasen aufgrund der induzierten Spannung drehzahlabhängige Ströme. Außerdem wirkt ein im Betrag geringes Kurzschlussmoment. Ein beispielhafter Verlauf ist dazu in Figur 1 dargestellt. Die x-Achse der Figur 1 bezeichnet die Drehzahl in U/min, die y-Achse bezeichnet die Amplitude des gemessenen Phasenstroms in Ampere beziehungsweise das Drehmoment in Nm.

Der Verlauf des gemessenen Phasenstroms über der Drehzahl ist in der oberen Kurve der Figur 1, der Verlauf des Drehmoments ist in der unteren Kurve in Figur 1 dargestellt. Es ist zu ersehen, dass die Größe des gemessenen Phasenstroms über einen breiten Drehzahlbereich oberhalb etwa 2000 U/min sehr konstant ist, wenn die Drehzahl während der Messung über der Zeit konstant ist. Ebenso verläuft das gemessene Kurzschlussdrehmoment über einen breiten Drehzahlbereich oberhalb etwa 2000 U/min im Wesentlichen konstant.

Ermittelt man nun im Kurzschlussbetrieb die Phasenströme einer Drehfeldmaschine von der bekannt ist, dass diese und ihre korrekt kalibrierten Stromsensoren einwandfrei funktionieren, können die gemessenen Werte als Referenzwerte zur Diagnose der Stromsensoren dieser oder anderer gleichartiger Drehfeldmaschinen herangezogen werden. Dabei kann außerdem ein bestimmter Toleranzbereich für die jeweils ermittelten Werte vorgegeben werden, in dem diese von den Referenzwerten abweichen dürfen, ohne dass daraus ein Defekt des Stromsensors oder eine nicht korrekte Funktionsweise abgeleitet werden. Gewisse Schwankungen der ermittelten Werte für gleichartig hergestellte Drehfeldmaschinen können sich beispielsweise aus Bauteiltoleranzen und Fertigungstoleranzen ergeben.

Um die Überprüfung von Stromsensoren im laufenden Betrieb einer Drehfeldmaschine durchzuführen, wird die Drehfeldmaschine aus einem Normalbetrieb heraus für eine (sehr) kurze Zeitdauer von zum Beispiel 3 bis 6 Grundschwingungsperioden in einen Kurzschlussbetrieb versetzt und darauf folgend wiederum in den Normalbetrieb. Während dieser kurzen Zeitdauer des Kurzschlussbetriebes ist kein Betrieb der Drehfeldmaschine mit Abgabe von Drehmoment möglich. Bei einem beispielhaften Betrieb eines Elektromotors in einem Hybridantrieb für ein Fahrzeug ist das Messverfahren leicht anwendbar, da ein Antrieb in diesem Anwendungsfall häufig kein Drehmoment zur Verfügung stellen muss. In all diesen Fällen wird vorzugsweise vorgesehen, dass die Übergänge von einem Normalbetrieb auf einen Kurzschlussbetrieb und umgekehrt ruckfrei ausgeführt werden. Dies kann zum Beispiel durch eine entsprechende Steuerung realisiert werden, die in Hard- oder Software oder einer Mischung aus beidem ausgeführt sein kann.

Nachfolgend wird beschrieben, welche Fehlerzustände von Stromsensoren einer n-phasigen Drehfeldmaschine durch eine Messung des Kurzschlussstromes und eines Vergleiches mit Referenzwerten dabei bestimmt werden können.
1. Bei einer Feststellung einer Offset-Abweichung zwischen Istwerten und Sollwerten für einen oder mehrere Stromsensoren, die größer ist als ein vorgegebener Schwellenwert, ergibt sich ein Hinweis auf eine Notwendigkeit zur Nachkalibrierung eines oder mehrerer der Stromsensoren.
2. Bei einer Feststellung einer Verstärkungsabweichung zwischen Istwerten und Sollwerten für einen oder mehrere Stromsensoren, die größer ist als ein vorgegebener Schwellenwert, ergibt sich ein Hinweis auf eine Notwendigkeit zur Nachkalibrierung eines oder mehrerer der Stromsensoren.
3. Bei einer Feststellung eines Kurzschlusses eines Stromsensors gegen Masse oder gegen eine Versorgungsspannung ergibt sich ein Hinweis auf einen Defekt des Stromsensors oder auf eine defekte Verbindung zwischen dem Stromsensor und einer nachgeschalteten Einheit.
4. Bei einer Feststellung von Abweichungen zwischen den Sollwerten und Istwerten für alle n-1 Stromsensoren, die größer sind als ein vorgegebener Schwellenwert, ergibt sich ein Hinweis auf eine Entmagnetisierung der Drehfeldmaschine.
5. Bei einer Feststellung eines Istwertes von Null für einen Stromsensor und bei einer Feststellung von um einen bestimmeten Wert phasenversetzten und in der Amplitude um mehr als einen vorgegebenen Wert von den Sollwerten abweichenden Istwerten für alle anderen Stromsensoren ergibt sich ein Hinweis auf eine Unterbrechung der zu dem einen Stromsensor gehörigen Verbindung zwischen der Drehfeldmaschine und einem zugehörigen Umrichter.

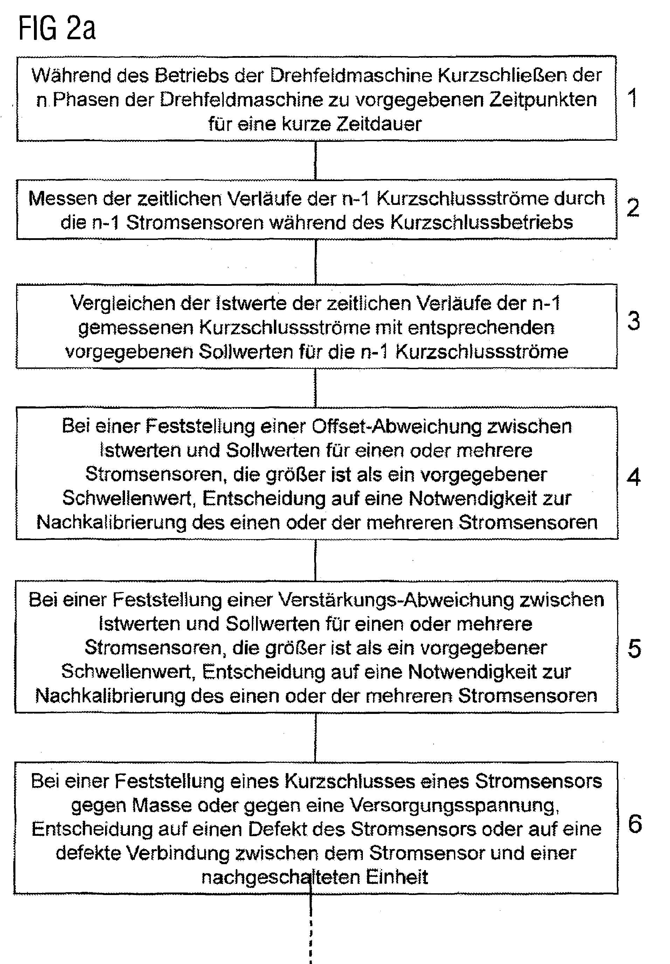

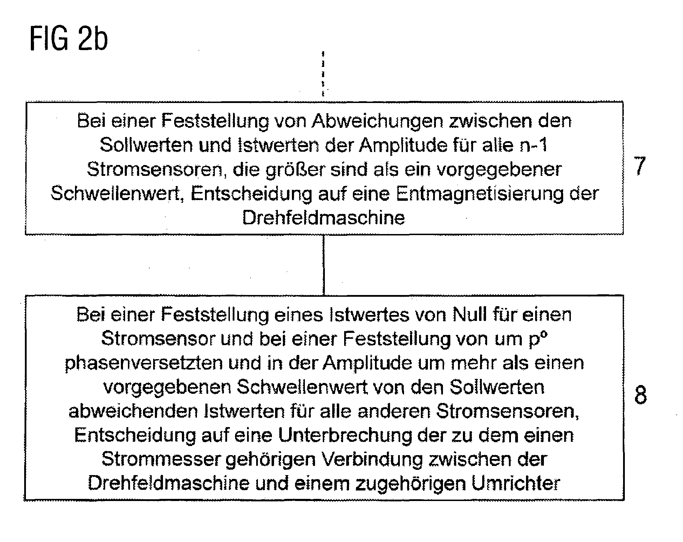

Figur 2 zeigt in einem Ablaufdiagramm eine Ausführungsform des erfindungsgemäßen Verfahrens zur Diagnose von Stromsensoren einer n-phasigen Drehfeldmaschine mit mindestens n-1 Stromsensoren während deren Betriebs. Für die folgenden Betrachtungen wird aber davon ausgegangen, dass es n-1 Stromsensoren sind. In einem ersten Schritt 1 werden während des Normalbetriebs der Drehfeldmaschine die n Phasen der Drehfeldmaschine bei konstanter Drehzahl der Drehfeldmaschine zyklisch zu vorgegebenen Zeitpunkten für eine kurze Zeitdauer kurzgeschlossen. In einem Schritt 2 werden während des Kurzschlussbetriebs die zeitlichen Verläufe der n-1 Kurzschlussströme durch die n-1 Stromsensoren gemessen. In einem Schritt 3 werden die Istwerte der zeitlichen Verläufe der n-1 gemessenen Kurzschlussströme mit entsprechenden vorgegebenen Sollwerten für die n-1 Kurzschlussströme verglichen.

Bei Feststellen einer Offset-Abweichung zwischen Ist- und Sollwerten für mindestens einen der Stromsensoren, die größer ist als ein vorgegebener Schwellenwert, wird in einem Schritt 4 die Notwendigkeit zur Nachkalibrierung eines oder mehrerer der Stromsensoren erkannt. In einem Schritt 5 wird bei Feststellen einer Verstärkungs-Abweichung zwischen Istwerten und Sollwerten für mindestens einen der Stromsensoren, die größer ist als ein vorgegebener Schwellenwert, auf eine Notwendigkeit zur Nachkalibrierung des mindestens einen Stromsensors entschieden. In einem Schritt 6 wird bei Feststellen eines Kurzschlusses eines Stromsensors gegen Masse oder gegen eine Versorgungsspannung auf einen Defekt des Stromsensors oder auf eine defekte Verbindung zwischen dem Stromsensor und einer nachgeschalteten Einheit entschieden.

In einem Schritt 7 wird bei Feststellen von Abweichungen zwischen den Sollwerten und Istwerten der Amplitude für alle.n-1 Stromsensoren, die größer sind als ein vorgegebener Schwellenwert, eine Entmagnetisierung der Drehfeldmaschine erkannt. In einem Schritt 8 wird bei Feststellen eines Istwertes von Null für einen Stromsensor und bei Feststellen von um einen bestimmten Wert phasenversetzten und in der Amplitude um mehr als einen vorgegebenen Wert von den Sollwerten abweichenden Istwerten für alle anderen Stromsensoren auf eine Unterbrechung der zu dem einen Strommesser gehörigen Verbindung zwischen der Drehfeldmaschine und einem zugehörigen Umrichter entschieden.

Wenn die Drehzahl der Drehfeldmaschine während eines Kurzschlussbetriebes um mehr als einen vorgegebenen Schwellenwert schwankt, werden die gemessenen Istwerte verworfen und zum nächsten Zeitpunkt eines Kurzschlussbetriebs wird eine erneute Messung und Auswertung durchgeführt. Die Reihenfolge der Verfahrensschritte 4 bis 8 ist dabei nicht zwingend die in der Figur 2 gezeigte. Im Allgemeinen können die Verfahrensschritte 4 bis 8 in beliebiger Reihenfolge ausgeführt werden. In einer bevorzugten Ausführungsform des Verfahrens wird die Feststellungen auf Abweichungen zwischen Sollwerten und Istwerten in einer Reihenfolge mit abnehmender statistischer Wahrscheinlichkeit des Auftretens der Abweichungen durchgeführt. Die statistisch am wahrscheinlichsten auftretenden Fehler werden auf diese Weise zuerst überprüft, um das Verfahren zeitlich so effizient wie möglich umzusetzen.

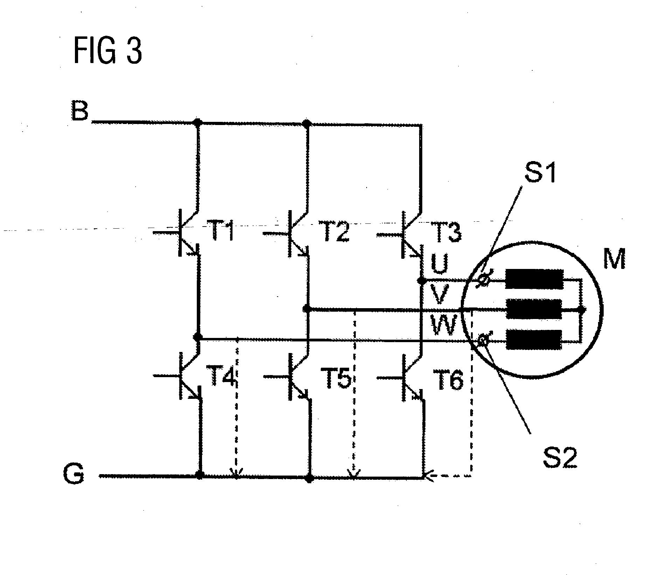

Zum Kurzschließen kann der üblicherweise ohnehin vorhandene Antriebsumrichter (insbesondere dessen elektronische Schalter) oder sonstige insbesondere elektronische Schalter im Speisekreis des Motors verwendet werden. Figur 3 zeigt hierzu ein vereinfachtes Beispiel, bei welchem ein Antriebsumrichter für einen drei-phasigen Motor M, der folglich drei Zuleitungen U, V, W hat, von denen zwei U, W mit einem Stromsensor S1 und S2 versehen sind. Der Antriebsumrichter umfasst unter Anderem eine sogenannte B6-Brückenschaltung mit 6 elektronischen Schaltern (in Form von Transistoren) T1 bis T6 wie z. B. IGBTs, MOSFETs etc. aufweist. Von dem jeweiligen Anschluss des Motors M führen dabei drei Schalter T4, T5, T6 auf Masse G und drei Schalter T1, T2, T3 auf Versorgungspotential B. Zum Kurzschließen werden die Schalter T4, T5, T6 durchgeschaltet und die Schalter T1, T2, T3 geöffnet (bzw. umgekehrt).

## Patentansprüche

1. Verfahren zur Diagnose von n-1 Stromsensoren (S₁, S₂) im Speisekreis einer n-phasigen Drehfeldmaschine (M), bei welchem
während des laufenden Betriebs der Drehfeldmaschine die n Phasen der Drehfeldmaschine zu vorgegebenen Zeitpunkten für einen Kurzschlussbetrieb für eine kurze Zeitdauer kurzgeschlossen werden,
während des Kurzschlussbetriebs die zeitlichen Verläufe der n-1 Kurzschlussströme durch die n-1 Stromsensoren gemessen werden, und
die Istwerte der zeitlichen Verläufe der n-1 gemessenen Kurzschlussströme mit entsprechenden vorgegebenen Sollwerten für die n-1 Kurzschlussströme verglichen werden.

2. Verfahren nach Anspruch 1, bei dem bei einer Feststellung einer Offset-Abweichung zwischen Istwerten und Sollwerten für einen oder mehrere Stromsensoren, die größer ist als ein vorgegebener erster Schwellenwert, auf eine Notwendigkeit zur Nachkalibrierung des einen oder der mehreren Stromsensoren entschieden wird.

3. Verfahren nach Anspruch 1, bei dem bei einer Feststellung einer Verstärkungs-Abweichung zwischen Istwerten und Sollwerten für einen oder mehrere Stromsensoren, die größer ist als ein vorgegebener zweiter Schwellenwert, auf eine Notwendigkeit zur Nachkalibrierung des einen oder der mehreren Stromsensoren entschieden wird.

4. Verfahren nach Anspruch 1, bei dem bei einer Feststellung eines Kurzschlusses eines Stromsensors gegen Masse oder gegen eine Versorgungsspannung auf einen Defekt des Stromsensors oder auf eine defekte Verbindung zwischen dem Stromsensor und einer nachgeschalteten Einheit entschieden wird.

5. Verfahren nach Anspruch 1, bei dem bei einer Feststellung von Abweichungen zwischen den Sollwerten und Istwerten der Amplitude für alle n-1 Stromsensoren, die größer sind als ein vorgegebener dritter Schwellenwert, auf eine Entmagnetisierung der Drehfeldmaschine entschieden wird.

6. Verfahren nach Anspruch 1, bei dem bei einer Feststellung eines Istwertes von Null für einen Stromsensor und bei einer Feststellung von um einen bestimmten vierten Schwellwert phasenversetzten und in der Amplitude um mehr als einen vorgegebenen fünften Schwellenwert von den Sollwerten abweichenden Istwerten für alle anderen Stromsensoren auf eine Unterbrechung der zu dem einen Stromsensor gehörigen Verbindung zwischen der Drehfeldmaschine und einem zugehörigen Umrichter entschieden wird.

7. Verfahren nach einem der Ansprüche 1 bis 6, bei dem der Übergang vom Normalbetrieb zum Kurzschlussbetrieb und umgekehrt durch eine Steuerung für die Drehfeldmaschine ruckfrei ausgeführt wird.

8. Verfahren nach einem der Ansprüche 1, bei dem gemessene Istwerte verworfen und nicht zum Vergleich mit entsprechenden Sollwerten herangezogen werden, wenn die Drehzahl der Drehfeldmaschine während eines Kurzschlussbetriebes um mehr als einen vorgegebenen sechsten Schwellenwert schwankt.

9. Verfahren nach einem der Ansprüche 1 bis 8, bei dem die Drehfeldmaschine Teil eines Hybridantriebs für ein Fahrzeug ist.

10. Verfahren nach einem der Ansprüche 1 bis 9, bei dem die Feststellungen der Abweichungen zwischen Sollwerten und Istwerten in einer Reihenfolge mit abnehmender statistischer Wahrscheinlichkeit des Auftretens der Abweichungen durchgeführt werden.

## Claims

1. Method for diagnosing n-1 current sensors (S₁, S₂) in the feed circuit of an n-phase induction machine (M) in which, during the ongoing operation of the induction machine, the n phases of the induction machine are short-circuited for a brief period of time at predetermined times,
the variations in time of the n-1 short-circuit currents through the n-1 current sensors are measured during a short-circuit operation, and
the actual values of the variations in time of the n-1 measured short-circuit currents are compared with corresponding predetermined target values for the n-1 short-circuit currents.

2. Method according to Claim 1, in which, when an offset deviation between actual values and target values is found for one or more current sensors, which is greater than a predetermined first threshold value, a necessity for recalibration of one or more current sensors is decided.

3. Method according to Claim 1, in which, when a gain deviation between actual values and target values is found for one or more current sensors, which is greater than a predetermined second threshold value, a necessity for recalibration of one or more current sensors is decided.

4. Method according to Claim 1, in which, when a short circuit of a current sensor to ground or to a supply voltage is found, a defect of the current sensor or a defective connection between the current sensor and a downstream unit is decided.

5. Method according to Claim 1, in which, when deviations are found between the target values and actual values of the amplitude for all n-1 current sensors, which are greater than a predetermined third threshold value, a demagnetization of the induction machine is decided.

6. Method according to Claim 1, in which, when an actual value of zero is found for a current sensor and when actual values offset in phase by a particular fourth threshold value and deviating in amplitude by more than a predetermined fifth threshold value from the target values are found for all other current sensors, an interruption of the connection, belonging to a current sensor, between the induction machine and an associated inverter is decided.

7. Method according to one of Claims 1 to 6, in which the transition from normal operation to short-circuit operation and conversely is carried out without jerks by a control system for the induction machine.

8. Method according to one of Claims 1 to 7, in which the measured actual values are discarded and not used for comparison with corresponding target values if the rotational speed of the induction machine fluctuates by more than a predetermined sixth threshold value during a short-circuit operation.

9. Method according to one of Claims 1 to 8, in which the induction machine is a part of a hybrid drive mechanism for a vehicle.

10. Method according to one of Claims 1 to 9, in which the findings of the deviations between target values and actual values are carried out in an order with decreasing statistical probability of the occurrence of the deviations.

## Revendications

1. Procédé de diagnostic de n-1 capteurs de courant (S1, S2) dans le circuit d'alimentation d'une machine à induction à n phases (M), dans lequel, pendant le fonctionnement continu de la machine à induction, les n phases de la machine à induction sont mises en court-circuit à des moments prédéfinis en vue d'un fonctionnement en mode de court-circuit pendant une courte durée,
pendant le fonctionnement en mode de court-circuit, les déroulements dans le temps des n-1 courants de court-circuit sont mesurés par les n-1 capteurs de courant, et
les valeurs effectives des déroulements dans le temps des n-1 courants de court-circuit mesurés sont comparées à des valeurs théoriques prédéfinies correspondantes pour les n-1 courants de court-circuit.

2. Procédé selon la revendication 1, dans lequel lorsqu'une déviation du décalage supérieure à une première valeur de seuil prédéfinie est constatée entre les valeurs effectives et les valeurs théoriques pour un ou plusieurs capteurs de courant, on conclut à la nécessité d'un recalibrage du ou des capteurs de courant concernés.

3. Procédé selon la revendication 1, dans lequel lorsqu'une déviation de l'amplification supérieure à une deuxième valeur de seuil prédéfinie est constatée entre les valeurs effectives et les valeurs théoriques pour un ou plusieurs capteurs de courant, on conclut à la nécessité d'un recalibrage du ou des capteurs de courant concernés.

4. Procédé selon la revendication 1, dans lequel lorsqu'un court-circuit d'un capteur de courant contre la masse ou contre une tension d'alimentation est constaté, on conclut à un défaut du capteur de courant ou à un raccordement défectueux entre le capteur de courant et une unité montée en aval.

5. Procédé selon la revendication 1, dans lequel lorsque des déviations supérieures à une troisième valeur de seuil prédéfinie sont constatées entre les valeurs théoriques et les valeurs effectives de l'amplitude pour tous les n-1 capteurs de courant, on conclut à une démagnétisation de la machine à induction.

6. Procédé selon la revendication 1, dans lequel lorsqu'une valeur effective nulle est constatée pour un capteur de courant et que des valeurs effectives en décalage de phase d'une quatrième valeur de seuil déterminée et déviant des valeurs théoriques d'une amplitude de plus d'une cinquième valeur de seuil prédéfinie sont constatées pour tous les autres capteurs de courant, on conclut à une interruption du raccordement inhérent au premier capteur de courant entre la machine à induction et un convertisseur y afférent.

7. Procédé selon l'une des revendications 1 à 6, dans lequel le passage du fonctionnement normal au fonctionnement en mode de court-circuit et inversement est exécuté sans à-coups par une commande pour la machine à induction.

8. Procédé selon la revendication 1, dans lequel des valeurs effectives mesurées sont rejetées et ne sont pas utilisées pour la comparaison avec des valeurs théoriques correspondantes lorsque la vitesse de rotation de la machine à induction varie de plus d'une sixième valeur de seuil prédéfinie pendant un fonctionnement en mode de court-circuit.

9. Procédé selon l'une des revendications 1 à 8, dans lequel la machine à induction fait partie d'un entraînement hybride pour un véhicule.

10. Procédé selon l'une des revendications 1 à 9, dans lequel les constatations des déviations entre les valeurs théoriques et les valeurs effectives sont réalisées dans un ordre selon une probabilité statistique décroissante de la survenue des déviations.
